# EUROPEAN PATENT SPECIFICATION

(11) **EP 2 390 907 B1**
(45) Date of publication and mention of the grant of the patent: **14.11.2012**
(21) Application number: 11003289.3
(22) Date of filing: 19.04.2011
(51) Int. Cl.: H01L 21/762, H01L 29/66

(54) **Trench structure in multilayer wafer**
Grabenstruktur in Mehrschichtwafer
Structure de tranchée dans une tranche multicouche

(30) Priority: 25.05.2010 EP 10290274
(43) Date of publication of application: 30.11.2011
(73) Proprietor: Soitec, 38190 Bernin (FR)
(72) Inventor: Bourdelle, Konstantin, 38920 Crolles (FR); Mazure, Carlos, 38190 Bernin (FR)
(74) Representative: Grünecker, Kinkeldey, Stockmair & Schwanhäusser

(56) References cited:
- EP-A1- 0 645 808
- DE-A1-102006 029 701
- US-A1- 2002 195 637
- US-A1- 2008 157 260
- US-A1- 2009 184 356
- US-B1- 6 486 038
- US-B1- 6 524 929

## Description

### Field of Invention

The present invention relates to the manufacture of multilayer, wafers, in particular, ultra thin buried oxide (UTBOX) wafers particularly designed for the fabrication of CMOS devices. The invention, more particular, relates to the manufacture of shallow trench isolation (STI) module intended for the electrical insulation of individual MOSFETs.

### Background of the invention

Silicon on thin buried oxide layers or ultra thin buried oxide (UTBOX) are advantageously characterized by small variations of the threshold-voltage and, thus, of growing interest in present and future CMOS technology. In particular, the fully depleted CMOS technology allows for low-voltages and low-power circuits operating at high speeds. Moreover, fully depleted SOI devices are considered as most promising candidates for allowing for reduced short channel effects (SCE).

Silicon on Insulator (SOI) wafers and, in particular, UTBOX wafers form the basis for the high-performance MOSFET and CMOS technology. The control of the SCE is mainly facilitated by the thinness of the active silicon layer formed above the insulator, i.e. buried oxide (BOX) layer. In order to reduce the coupling effect between source and drain and, furthermore, with respect to the scalability of thin film devices for future technologies, the provision of very thin BOX layers is mandatory. Control of the threshold voltage also depends of the thinness of the BOX layers. Appropriate implantation of the substrate below the BOX layer allows for accurate adjustment of the threshold voltage by back biasing.

In the manufacture of SOI devices, in particular, CMOS devices usually trenches have to be formed, for example, in order to electrically isolate individual MOSFETs from each other. The formed trenches can be cleaned, slightly oxidized, and subsequently filled with an oxide liner and some insulator material above the liner and, thereby, shallow trench isolation (STI) structures are formed. However, in the manufacture of such trench structures, for example, STIs, a problem in the form of the so-called Birds's Beak Effect arise. The Birds's Beak Effect in the context of the formation of trenches in SOI wafers is characterized by the increase in the thickness of the BOX layer in the areas close to the edges of a trench. One of the reasons behind the formation of Birds's Beak Effect can be related to some underetching of the BOX layer, for example, during a cleaning process that usually comprises hydrofluoric dipping. Another reason can be seen in lateral oxidation of a not completely closed bonding interface within the BOX layer in the case when the SOI wafer is manufactured by oxide-oxide bonding wherein, for example, a thin silicon layer is covered by an oxide layer, for example, an SiO₂ layer, and transferred to a substrate that is also covered by an oxide layer of the same type.

EP 0 645 808 discloses a method of avoiding a birds beak at the interface of a trench and a BOX layer by depositing a polysilicon layer into the trench.

Thus, there is a need for an improved method for the formation of trenches and corresponding isolator structures that alleviates the Birds's Beak Effect.

### Description of the Invention

The present invention addresses the above-mentioned need and, accordingly, provides a method for the manufacture of a trench structure in a multilayer wafer comprising a substrate, an oxide layer on the substrate and a semiconductor layer on the oxide layer, the method comprising the steps of
forming a trench through the semiconductor layer and the oxide layer (BOX layer) and extending into the substrate; and
performing an anneal treatment of the formed trench such that at the inner surface of the trench some material of the semiconductor layer flows at least over a portion of the part of the oxide layer exposed at the inner surface of the trench; and
filling the trench with an insulator material after the anneal treatment.

In particular, the substrate can be a silicon substrate, the oxide layer can be a silicon (di)oxide layer (SiO₂) and the semiconductor layer is a silicon layer, for example, a single crystal silicon layer.

By the step of the thermal anneal Bird's Beak effect during subsequent manufacturing steps based on the formed trench can effectively be reduced. The semiconductor material overflowing the oxide exposed in the trench prevents underetching of the semiconductor layer in subsequent cleaning processes and unintended lateral oxidation of the previously exposed oxide layer when forming an oxide liner, for example, on the inner surfaces of the trench.

According to an embodiment, a cleaning treatment of the trench after the anneal treatment is performed. The cleaning treatment may comprise cleaning with a hydrofluoric solution, in particular, dipping in a hydrofluoric solution. No underetching of the semiconductor layer is caused by the hydrofluoric solution due to the protecting coating by the material of the semiconductor layer flown due to the thermal annealing over the exposed oxide surface.

After the thermal anneal and cleaning treatment a formation of an oxide liner in the trench may be performed. The oxide liner may be formed by thermal oxidation of the wafer including the trench. The thickness of the formed oxide should be sufficient to consume the overflown semiconductor material and by doing that preventing the electrical short/connection between top Si layer and silicon substrate below the BOX layer.

The anneal treatment is performed, for example, at a temperature of at least 1100°C, in particular, at least 1150 °C and, more particularly, at least 1200 °C. Moreover, the anneal treatment can be performed in a hydrogen and/or argon atmosphere. The thermal anneal treatment can be performed for a rather short time period, for example, for at most 4 minutes, in particular, at most 3 minutes and, more particularly, at most 2 minutes.

In the above-described examples for the inventive method, the BOX layer may have a thickness in the range from 5 to 20 nm and the top semiconductor layer in an UTBOX wafer may have a thickness in the range from 10 to 50 nm. Thus, a trench can be formed in a UTBOX wafer comprising a very thin BOX layer and a thin silicon layer intended to serve as an active layer for a semiconductor device, for example, an SOI CMOS device. Since the Bird's Beak effect is particularly problematic for thin BOX layers it is to be noted that by the inventive provision of the thermal anneal process, even for such thin BOX layers of some 2 to 20 nm Bird's Beak effect can effectively be suppressed.

Furthermore, the multilayer wafer in the above examples may be provided by
forming a first oxide layer above the substrate;
forming a second oxide layer above another substrate; and
bonding the first and the second oxide layers within a wafer transfer process (therby forming the oxide layer, BOX layer, sandwiched by the substrate and the semiconductor layer, and removing the other substrate.

It is noted that in the case that the multilayer is provided in this manner, the thermal anneal step of the present invention advantageously results in a consolidation of the bonding interface of the first and second oxide layers (that form the BOX layer of the wafer) in the sense of a complete closing of the interface thereby resulting in an homogeneous BOX layer. Due to the thus achieved homogeneity of the BOX layer Bird's Beak Effect caused by lateral oxidation when forming by thermal oxidation an oxide liner at the inner surfaces of the trench can significantly be suppressed.

The present invention also provides a method for the manufacture of a semiconductor device, comprising the steps of
manufacturing the trench (structure) in the multilayer wafer according to one of the above-described examples;
forming a MOSFET over and partially in the multilayer wafer; and
forming another device over and/or in the multilayer wafer such that the other device is separated from the MOSFET by the trench (structure).

In particular, in this method the substrate may be doped to serve as a back-gate substrate and the other device may comprise a back-gate terminal intended for back-gate biasing.

Additionally, the present invention also provides a method for the manufacture of a trench capacitor in a multilayer wafer comprising a substrate, an oxide layer on the substrate and a semiconductor layer on the oxide layer, the method comprising the steps of
forming a trench through the semiconductor layer and the oxide layer and extending into the substrate;
performing an anneal treatment of the formed trench such that at the inner surface of the trench some material of the semiconductor layer flows at least over a portion of the part of the oxide layer exposed at the inner surface of the trench;
forming a node dielectric on the inside surfaces of the trench after the anneal treatment; and
filling a conductive material in the trench after the formation of the node dielectric.

One electrode is formed by the conductive material filled into the trench and the other may be formed by the (doped polysilicon) substrate.

Additional features and advantages of the present invention will be described with reference to the drawings. In the description, reference is made to the accompanying figures that are meant to illustrate preferred embodiments of the invention. It is understood that such embodiments do not represent the full scope of the invention.
Figures 1a and 1f illustrate an example of a method for the manufacture of an STI in an SOI wafer according to the present invention.
Figure 2 illustrates a part of a silicon on ultra thin BOX device according to an example of the present invention.

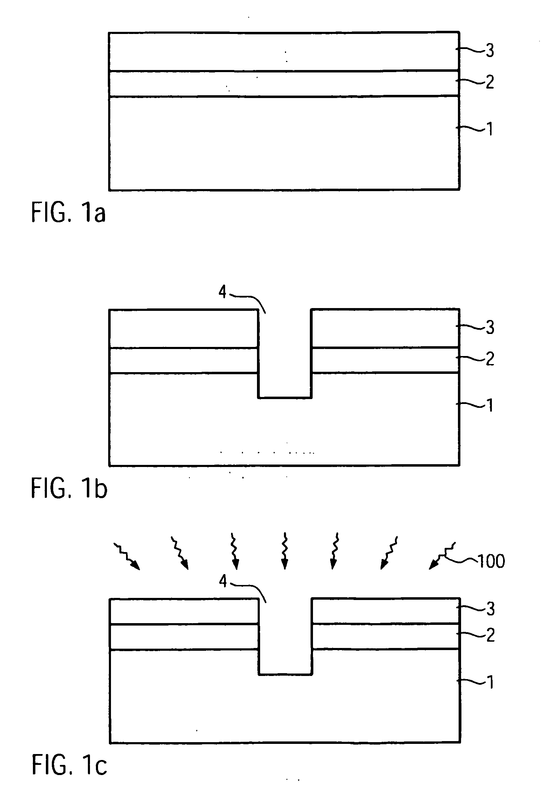

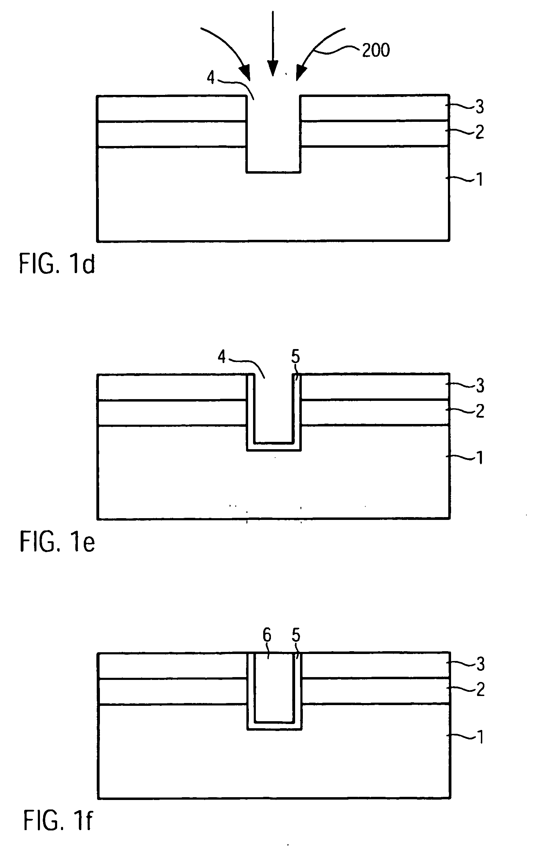

In the following, an example for the inventive method of forming a trench structure in a multiplayer wafer is described. A wafer as shown in Figure 1 a is provided. The multi-layer wafer comprises a substrate 1, a first layer 2 and a second layer 2. According to the present example, the multiplayer wafer is an SOI wafer, i.e. the substrate 1 is a silicon substrate 1, the first layer 2 is an oxide layer (a BOX layer) and the second layer 3 is a silicon layer 3. The multilayer wafer show in Figure 1a may be obtained by some wafer transfer technique as known in the art. For example, a silicon layer 3 may be grown on a donator substrate and, subsequently, a silicon (di)oxide layer is formed on the silicon layer 3. On the other hand, a silicon (di)oxide layer is formed on the substrate 1. During the wafer transfer process the oxide layer formed on the silcon layer 3 and the oxide layer formed on the substrate 1 are bonded to each other and the donor substrate is removed leaving the wafer comprising the substrate 1, the oxide layer 2 and the silicon layer 3.

In the wafer shown in Figure 1a a trench 4 is formed through the silicon layer 3 and the oxide layer 2 and extending into the substrate 1 as it is shown in Figure 1 b. Formation of the trench may be facilitated by forming a mask layer, for example, a nitride mask layer atop of the silicon layer 3 and a photoresist atop of the mask layer (not shown). After patterning the trench 4 can be etched and both the mask layer and the photoresist are removed.

After the formation of the trench 4 in the multiplayer wafer a rapid thermal anneal process 100 is performed (see Figure 1c). For this, the wafer (the trench) is subject to an anneal atmosphere, for example, built of hydrogen and/or argon at a temperature of at least 1100 °C, for example, 1150 °C, in particular, 1200 °C or 1250°C or more, and for at most 4 minutes, for example, at most 2 or 3 minutes. The rapid thermal anneal process 100 results is some flow of the silicon of the silicon layer 3 at the inside surface of the trench 4 such that the flowing silicon at least partially covers the part of the oxide layer 2 that is exposed at the inner surface of the trench 4. Thereby, the Bird's Beak Effect is suppressed during the subsequent manufacturing procedure.

Next, the trench 4 is cleaned 200 by a hydrofluorid solution as shown in Figure 1 d. For example, a 10 % to 20% hydrofluorid solution may be used for dip cleaning of the wafer and the trench 4. Underetching of the silicon layer 3 is effectively prevented by the previously performed anneal treatment 100. After the cleaning process 200 an oxide liner 5 is formed on the inner surfaces of the trench 4 (see Figure 1e). The oxide liner 5 can be formed by thermal oxidation, for example, in an oxygen atmosphere, in particular, comprising O₂/H₂ or O₂/H₂/HCl or O₂/HC and/or at a temperature of 800 °C to 1000°C.

Again, the Bird's Beak Effect that might otherwise be caused by lateral oxidation of an imperfectly closed oxide-oxide interface within the oxide layer 2 that may result from the above-described wafer transfer is suppressed by the previously performed anneal treatment 100.

According to the shown example, the trench is filled with some isolator material 6, for example, some nitride or oxide material, to finish the formation of an STI (see Figure 1f). By such an STI different individual MOSFETs, for example, can be separated from each other. The separated MOSFETs may be of different conductivity types and may be part of a CMOS device.

The above-described manner of forming the trench structure shown in Figures 1c and 1d may also be used for the formation of a trench capacitor and, in particular, for the formation of a memory cell, for example, a DRAM cell on SOI, comprising such a trench capacitor. For this purpose, on the inner surfaces of the trench 4 shown in Figures 1c or 1d a node dielectric, for example, of silicon nitride or silicon oxide, is formed and, subsequently, the trench 4 is filled with a electrically conductive material, for example, a metal like copper, nickel, etc; or n+ doped polysilicon. Such a trench capacitor can be connected to an access transistor that is also formed on and partially in the multilayer wafer.

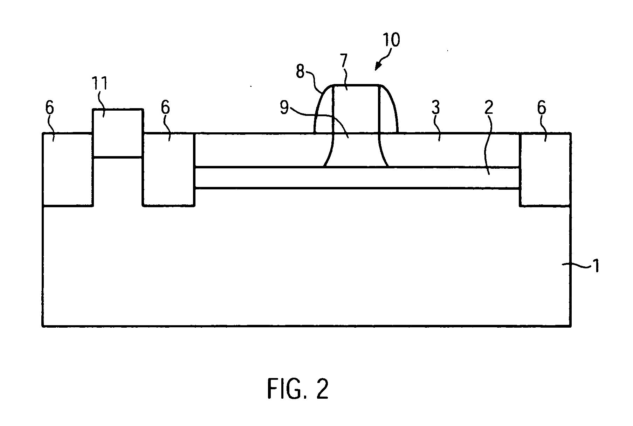

In Figure 2 another application for the inventive method of manufacturing a trench structure and particularly an STI is illustrated. In the shown example, a silicon on UTBOX device is shown that comprises a MOSFET 10 comprising a gate electrode 7 and sidewall spacers 8. In the active silicon layer 3 a channel region 9 is formed below the gate electrode 7. Source/drain regions are formed adjacent to the channel region in the silicon layer 3. Below the silicon layer 3 a very thin BOX layer 2 is located that is formed on a polysilicon substrate 1. The substrate 1 below the active region of the MOSFET 10 is appropriately doped to function as a back-gate substrate. Moreover, the shown device comprises a back-gate terminal 11 located between STIs 6. Another STI 6 limits the shown active region on the right-hand side. It is noted that silicide regions may be formed adjacent to the sidewall spacers 8 and that it might be preferred that the gate electrode is at least partially silicidized.

In the example shown in Figure 2 is it particularly advantageous to provide STIs manufactured according to the present invention, i.e., formed by process steps including the thermal anneal as it is described with reference to Figure 1c thereby avoiding the Bird's Beak Effect that otherwise would result in a significant deterioration of the performance of the finished silicon on UTBOX (CMOS) device.

All previously discussed embodiments are not intended as limitations but serve as examples illustrating features and advantages of the invention. It is to be understood that some or all of the above described features can also be combined in different ways.

## Claims

1. Method for the manufacture of a trench (4) structure in a multilayer wafer comprising a substrate (1), an oxide layer (2) on the substrate (1) and a semiconductor layer (3) on the oxide layer (2), the method comprising the steps of
forming a trench (4) through the semiconductor layer (3) and the oxide layer (2) and extending into the substrate (1);
performing an anneal treatment of the formed trench (4) such that at the inner surface of the trench (4) some material of the semiconductor layer (3) flows at least over a portion of the part of the oxide layer (2) exposed at the inner surface of the trench (4); and
filling the trench (4) with an insulator material after the anneal treatment.

2. The method according to claim 1, further comprising performing a cleaning treatment of the trench (4) after the anneal treatment.

3. The method according to claim 2, wherein the cleaning treatment comprises cleaning with a hydrofluoric solution, in particular, dipping in a hydrofluoric solution.

4. The method according to one of the preceding claims, wherein the anneal treatment is performed at a temperature of at least 1100°C, in particular, at least 1150 °C and, more particularly, at least 1200 °C.

5. The method according to claim 4, wherein the anneal treatment is performed in a hydrogen and/or argon atmosphere.

6. The method according to claim 4 or 5, wherein the anneal treatment is performed for at most 4 minutes, in particular, at most 3 minutes and, more particularly, at most 2 minutes.

7. The method according to one of the preceding claims, wherein the substrate (1) comprises or consists of silicon, in particular, polysilicon, and/or the oxide layer (2) comprises SiO₂ and/or the semiconductor layer (3) comprises or consists of silicon, in particular, single crystal silicon.

8. The method according to one of the preceding claims, wherein the oxide layer (2) has a thickness in the range from 5 to 20 nm and/or the semiconductor layer (3) has a thickness in the range from 10 to 50 nm.

9. The method according to one of the preceding claims, further comprising providing the multilayer wafer by
forming a first oxide layer (2) above the substrate (1);
forming a second oxide layer (2) above another substrate (1);
bonding the first and the second oxide layer (2)s within a wafer transfer process and removing the other substrate (1).

10. The method according to one of the preceding claims, further comprising forming, in particular, by thermal oxidation, an oxide liner in the trench (4) after the anneal treatment.

11. Method for the manufacture of a semiconductor device, comprising the steps of
manufacturing the trench (4) structure in the multilayer wafer according to one of the preceding claims;
forming a MOSFET (10) over and partially in the multilayer wafer; and
forming another device over and/or in the multilayer wafer such that the other device is separated from the MOSFET (10) by the trench (4) structure.

12. The method according to claim 11, wherein the substrate (1) is doped to serve as a back-gate substrate (1) and the other device comprises a back-gate terminal (11).

13. Method for the manufacture of a trench (4) capacitor in a multilayer wafer comprising a substrate (1), an oxide layer (2) on the substrate (1) and a semiconductor layer (3) on the oxide layer (2), the method comprising the steps of
forming a trench (4) through the semiconductor layer (3) and the oxide layer (2) and extending into the substrate (1);
performing an anneal treatment of the formed trench (4) such that at the inner surface of the trench (4) some material of the semiconductor layer (3) flows at least over a portion of the part of the oxide layer (2) exposed at the inner surface of the trench (4);
forming a node dielectric on the inside surfaces of the trench (4) after the anneal treatment; and
filling a conductive material in the trench (4) after the formation of the node dielectric.

## Patentansprüche

1. Verfahren zur Herstellung einer Grabenstruktur (4) in einem Mehrschicht-Wafer mit einem Substrat (1), einer Oxidschicht (2) auf dem Substrat (1) und einer Halbleiterschicht (3) auf der Oxidschicht (2), wobei das Verfahren die Schritte umfasst
Bilden eines Grabens (4) durch die Halbleiterschicht (3) und die Oxidschicht (2), der sich in das Substrat (1) erstreckt;
Ausführen einer Aufheizbehandlung des gebildeten Grabens (4), so dass Material der Halbleiterschicht (3) an der inneren Oberfläche des Grabens (4) zumindest über einen Bereich des Teils der Oxidschicht (2) fließt, der an der inneren Oberfläche des Grabens (4) freigelegt ist; und
Füllen des Grabens (4) mit einem Isoliermaterial nach der Aufheizbehandlung.

2. Das Verfahren gemäß Anspruch 1, das weiterhin ein Ausführen einer Reinigungsbehandlung des Grabens (4) nach der Aufheizbehandlung umfasst.

3. Das Verfahren gemäß Anspruch 2, in dem die Reinigungsbehandlung Reinigen mit einer Hydrofluor-Lösung, insbesondere Eintauchen in eine Hydrofluor-Lösung, umfasst.

4. Das Verfahren gemäß einem der vorhergehenden Ansprüche, in dem die Aufheizbehandlung bei einer Temperatur von zumindest 1100 °C, insbesondere zumindest 1150 °C und weiterhin insbesondere zumindest 1200 °C, ausgeführt wird.

5. Das Verfahren gemäß Anspruch 4, in dem die Aufheizbehandlung in einer Wasserstoff- und/oder Argonatmosphäre ausgeführt wird.

6. Das Verfahren gemäß Anspruch 4 oder 5, in dem die Aufheizbehandlung über höchstens 4 Minuten, insbesondere höchstens 3 Minuten und weiterhin insbesondere höchsten 2 Minuten, ausgeführt wird.

7. Das Verfahren gemäß einem der vorhergehenden Ansprüche, in dem das Substrat (1) Silizium, insbesondere Polysilizium, umfasst oder daraus besteht und/oder die Oxidschicht (2) SiO₂ umfasst und/oder die Halbleiterschicht (3) Silizium, insbesondere Einkristallsilizium, umfasst oder daraus besteht.

8. Das Verfahren gemäß einem der vorhergehenden Ansprüche, in dem die Oxidschicht (2) eine Dicke im Bereich von 5 bis 20 nm und/oder die Halbleiterschicht (3) eine Dicke im Bereich von 10 bis 50 nm aufweist.

9. Das Verfahren gemäß einem der vorhergehenden Ansprüche, das weiterhin das Bereitstellen des Mehrschicht-Wafers durch
Bilden einer ersten Oxidschicht (2) über dem Substrat (1);
Bilden einer zweiten Oxidschicht (2) über einem anderen Substrat (1);
Bondieren der ersten und zweiten Oxidschicht (2) im Rahmen eines Wafertransferprozesses und Entfernen des anderen Substrats (1)
umfasst.

10. Das Verfahren gemäß einem der vorhergehenden Ansprüche, das weiterhin das Bilden, insbesondere durch thermische Oxidation, einer Oxidschicht in dem Graben (4) nach der Aufheizbehandlung umfasst.

11. Verfahren zur Herstellung eines Halbleiterbauteils, das die Schritte umfasst:
Bilden der Grabenstruktur (4) in dem Mehrschicht-Wafer gemäß einem der vorhergehenden Ansprüche;
Bilden eines MOSFET (10) über und teilweise in dem Mehrschicht-Wafer; und
Bilden eines weiteren Bauteils über und/oder in dem Mehrschicht-Wafer, so dass das andere Bauteil durch die Grabenstruktur (4) von dem MOSFET (10) getrennt ist.

12. Das Verfahren gemäß Anspruch 11, in dem das Substrat (1) dotiert ist, so dass es als ein Back-Gate-Substrat (1) dient, und das andere Bauteil einen Back-Gate-Anschluss umfasst.

13. Verfahren zur Herstellung eines Grabenkondensators (4) in einem Mehrschicht-Wafer mit einem Substrat (1), einer Oxidschicht (2) auf dem Substrat (1) und einer Halbleiterschicht (3) auf der Oxidschicht (2), wobei das Verfahren die Schritte umfasst Ausführen einer Aufheizbehandlung des gebildeten Grabens (4), so dass Material der Halbleiterschicht (3) an der inneren Oberfläche des Grabens (4) zumindest über einen Bereich des Teils der Oxidschicht (2) fließt, der an der inneren Oberfläche des Grabens (4) freigelegt ist;
Bilden eines Knotendielektrikums auf den inneren Oberflächen des Grabens (4) nach der Aufheizbehandlung; und
Füllen eines leitenden Materials in den Graben (4) nach dem Ausbilden des Knotendielektrikums.

## Revendications

1. Procédé de fabrication d'une structure de tranchée (4) dans une plaquette multicouche comprenant un substrat (1), une couche d'oxyde (2) sur le substrat (1) et une couche semi-conductrice (3) sur la couche d'oxyde (2), le procédé comprenant les étapes consistant à
former une tranchée (4) à travers la couche semi-conductrice (3) et la couche d'oxyde (2) et s'étendant dans le substrat (1) ;
mettre en oeuvre un traitement de recuit de la tranchée formée (4) de telle sorte qu' à la surface interne de la tranchée (4) du matériau de la couche semi-conductrice (3) s'écoule au moins sur une portion de la partie de la couche d'oxyde (2) exposée à la surface interne de la tranchée (4) ; et
remplir la tranchée (4) d'un matériau isolant après le traitement de recuit.

2. Procédé selon la revendication 1, comprenant en outre la mise en oeuvre d'un traitement de nettoyage de la tranchée (4) après le traitement de recuit.

3. Procédé selon la revendication 2, dans lequel le traitement de nettoyage comprend un nettoyage avec une solution de fluorure d'hydrogène, en particulier par trempage dans une solution de fluorure d'hydrogène.

4. Procédé selon l'une des revendications précédentes, dans lequel le traitement de recuit est effectué à une température d'au moins 1100 °C, en particulier d'au moins 1150 °C, et plus en particulier d'au moins 1200 °C.

5. Procédé selon la revendication 4, dans lequel le traitement de recuit est effectué sous atmosphère d'hydrogène et/ou d'argon.

6. Procédé selon la revendication 4 ou 5, dans lequel le traitement de recuit est effectué durant au plus 4 minutes, en particulier durant au plus 3 minutes, et plus en particulier durant au plus 2 minutes.

7. Procédé selon l'une des revendications précédentes, dans lequel le substrat (1) comprend ou consiste en du silicium, en particulier du silicium polycristallin, et/ou la couche d'oxyde (2) comprend du SiO₂ et/ou la couche semi-conductrice (3) comprend ou consiste en du silicium, en particulier du silicium monocristallin.

8. Procédé selon l'une des revendications précédentes, dans lequel la couche d'oxyde (2) présente une épaisseur comprise entre 5 nm et 20 nm, et/ou la couche semi-conductrice (3) présente une épaisseur comprise entre 10 nm et 50 nm.

9. Procédé selon l'une des revendications précédentes, comprenant en outre la préparation de la plaquette multicouche consistant à :
former une première couche d'oxyde (2) au-dessus du substrat (1) ;
former une deuxième couche d'oxyde (2) au-dessus d'un autre substrat (1) ;
coller les première et deuxième couches d'oxyde (2) dans un processus de transfert de plaquette et enlever l'autre substrat (1).

10. Procédé selon l'une des revendications précédentes, comprenant en outre la formation, en particulier par oxydation thermique, d'un revêtement d'oxyde dans la tranchée (4) après le traitement de recuit.

11. Procédé de fabrication d'un dispositif semiconducteur, comprenant les étapes consistant à
fabriquer la structure de tranchée (4) dans la plaquette multicouche selon l'une des revendications précédentes ;
former un transistor MOSFET (10) par-dessus et partiellement dans la plaquette multicouche ; et
former un autre dispositif par-dessus et/ou dans la plaquette multicouche de telle manière que l'autre dispositif est séparé du transistor MOSFET (10) par la structure de tranchée (4).

12. Procédé selon la revendication 11, dans lequel le substrat (1) est dopé pour servir de substrat de contre-grille (1) et l'autre dispositif comprend une borne de contre-grille (11).

13. Procédé de fabrication d'un condensateur de tranchée (4) dans une plaquette multicouche comprenant un substrat (1), une couche d'oxyde (2) sur le substrat (1) et une couche semi-conductrice (3) sur la couche d'oxyde (2), le procédé comprenant les étapes consistant à
former une tranchée (4) à travers la couche semi-conductrice (3) et la couche d'oxyde (2) et s'étendant dans le substrat (1) ;
mettre en oeuvre un traitement de recuit de la tranchée formée (4) de telle sorte qu' à la surface interne de la tranchée (4) du matériau de la couche semi-conductrice (3) s'écoule au moins sur une portion de la partie de la couche d'oxyde (2) exposée à la surface interne de la tranchée (4) ;
former un diélectrique de noeud sur les surfaces internes de la tranchée (4) après le traitement de recuit ; et
remplir un matériau conducteur dans la tranchée (4) après la formation du diélectrique de noeud.
